# EUROPEAN PATENT APPLICATION

(11) **EP 4 608 101 A1**
(43) Date of publication of application: **27.08.2025**
(21) Application number: 25157340.8
(22) Date of filing: 12.02.2025
(51) Int. Cl.: H10F 77/60, H10F 77/50, H10F 39/00

(54) **THERMALLY ENHANCED ELECTRO-OPTICAL DEVICE**

(30) Priority: 22.02.2024 US 202418584492
(71) Applicant: STMicroelectronics International N.V., 1228 Plan-les-Ouates, Geneva (CH)
(72) Inventor: BOUTALEB, Younes, 38000 Grenoble (FR)
(74) Representative: Casalonga

(57) **Abstract**

In various embodiments, an electro-optical device is provided. The electro-optical device includes a transparent layer. The electro-optical device also includes a heat sink mechanically coupled to and embedding the transparent layer, where the heat sink includes a first heat sink section, and a second heat sink section. The electro-optical device also includes an electronic circuitry disposed on a substrate, a first pillar configured to mechanically couple the first heat sink section to the electronic circuitry and transfer heat generated by the electronic circuitry to the first heat sink section, and a second pillar configured to mechanically couple the second heat sink sections to the electronic circuitry and transfer heat generated by the electronic circuitry to the second heat sink section.

## Description

### TECHNICAL FIELD

Example embodiments of the present disclosure relate generally to thermal dissipation and in particular thermal dissipation in electro-optical devices.

### BACKGROUND

Various electro-optical devices may generate heat while performing their respective function. However, the temperature of various parts of the electro-optical device may need to be kept within working limits.

Applicant has identified many technical challenges and difficulties associated with thermal dissipation in electro-optical devices. Through applied effort, ingenuity, and innovation, Applicant has solved problems related to thermal dissipation by developing solutions embodied in the present disclosure, which are described in detail below.

### BRIEF SUMMARY

Various embodiments described herein relate to systems, apparatuses, devices, products, and/or methods for thermal improvement of an electro-optical device.

In various embodiments, an electro-optical device includes a transparent layer. The electro-optical device also includes a heat sink mechanically coupled to and embedding the transparent layer, where the heat sink includes a first heat sink section, and a second heat sink section. The electro-optical device also includes an electronic circuitry disposed on a substrate; a first pillar configured to mechanically couple the first heat sink section to the electronic circuitry, and transfer heat generated by the electronic circuitry to the first heat sink section, and a second pillar configured to: mechanically couple the second heat sink sections to the electronic circuitry; and transfer heat generated by the electronic circuitry to the second heat sink section.

In various embodiments, the first pillar and the second pillar comprise heat conductive glue. In various embodiments, the first pillar includes a first layer of copper mechanically coupled to the electronic circuitry and a first layer of solder mechanically coupled to the first heat sink section, and the second pillar includes a second layer of copper mechanically coupled to the electronic circuitry and a second layer of solder mechanically coupled to the second heat sink section.

In various embodiments, the first heat sink section includes a first ledge disposed between the first pillar and the transparent layer and mechanically coupled to the transparent layer using glue, and the second heat sink section includes a second ledge disposed between the second pillar and the transparent layer and mechanically coupled to the transparent layer using glue. In various embodiments, the first heat sink section includes one or more first fins and the second heat sink section includes one or more second fins, where the one or more first fins and the one or more second fins are configured to increase a thermal exchange surface between the heat sink and an environment, and increase a thermal dissipation of the heat sink.

In various embodiments, an electro-optical device includes a transparent layer, a heat sink includes a ledge, where the ledge is mechanically coupled to the transparent layer, an electronic circuitry disposed on a substrate, and a support configured to: mechanically couple the ledge of the heat sink to the electronic circuitry; and transfer heat generated by the electronic circuitry to the heat sink.

In various embodiments, the ledge of the heat sink is configured to mechanically couple to the transparent layer using glue. The electro-optical device may also include a cavity, where the cavity is generated between the transparent layer, the electronic circuitry, and the support.

In various embodiments, the support includes a first pillar and a second pillar, the heat sink includes a first heat sink section and a second heat sink section, the first pillar is configured to mechanically couple the first heat sink section to the electronic circuitry, and the second pillar is configured to mechanically couple the second heat sink section to the electronic circuitry. In various embodiments, the support includes heat conductive material.

In various embodiments, the transparent layer includes at least one of a lens, a lens array, a protection layer, or a refractive filter. In various embodiments, the electronic circuitry includes at least one of a light sensor, a photodiode, or a pixel. The electro-optical device may also include a molding material configured to surround the support, mechanically couple to and hold together the heat sink, the support, the electronic circuitry, and the substrate.

In various embodiments, the heat sink includes one or more fins configured to increase a thermal exchange surface between the heat sink and an environment, and increase a thermal dissipation of the heat sink.

In various embodiments, the support and the heat sink are configured to reduce a thermal resistance from the electronic circuitry to an environment. In various embodiments, the support and the heat sink are configured to maintain a maximum junction temperature of the electronic circuitry below a maximum junction temperature threshold. In various embodiments, the heat sink includes copper or copper alloy.

The electro-optical device may also include one or more bonding wires configured to electronically couple at least one of the light sensor, the photodiode, or the pixel to one or more electrical conductive traces of the substrate.

In various embodiments, an electro-optical device includes a transparent layer, a heat sink mechanically coupled to the transparent layer, an electronic circuitry disposed on a substrate, and a support configured to: mechanically couple the heat sink to the electronic circuitry; and transfer heat generated by the electronic circuitry to the heat sink. In various embodiments, the heat sink includes: an opening configured to embed the transparent layer. The electro-optical device may also include one or more fins configured to increase a thermal exchange surface between the heat sink and an environment, and increase a thermal dissipation of the heat sink. The electro-optical device may also include the electronic circuitry including one or more light sensitive components. The electro-optical device may also include the support surrounding the one or more light sensitive components.

The above summary is provided merely for purposes of summarizing some example embodiments to provide a basic understanding of some aspects of the disclosure. Accordingly, it will be appreciated that the above-described embodiments are merely examples and should not be construed to narrow the scope or spirit of the disclosure in any way. It will also be appreciated that the scope of the disclosure encompasses many potential embodiments in addition to those here summarized, some of which will be further described below. Other technical features may be readily apparent to one skilled in the art from the following figures, descriptions, and claims.

### BRIEF DESCRIPTION OF THE SEVERAL VIEWS OF THE DRAWINGS

FIG. 1 is a schematic diagram of an electro-optical device.
FIG. 2 is a schematic diagram of an electro-optical device in accordance with various embodiments.
FIG. 3 is a schematic diagram of an electro-optical device in accordance with various embodiments.
FIG. 4 is a schematic diagram of various parts of an electro-optical device in accordance with various embodiments.
FIG. 5 is a flow chart illustrating a method in accordance with various embodiments.

### DETAILED DESCRIPTION

Embodiments of the present disclosure will now be described more fully herein with reference to the accompanying drawings, in which some, but not all, embodiments of the disclosure are shown. Indeed, various embodiments of the disclosure may be embodied in many different forms and should not be construed as limited to the embodiments set forth herein; rather, these embodiments are provided so that this disclosure will satisfy applicable legal requirements. Like reference numerals refer to like elements throughout.

The phrases "in one embodiment," "according to one embodiment," "in some embodiments," "In various embodiments" and the like generally mean that the particular feature, structure, or characteristic following the phrase may be included in at least one embodiment of the present disclosure, and may be included in more than one embodiment of the present disclosure (importantly, such phrases do not necessarily refer to the same embodiment).

The word "example" or "exemplary" is used herein to mean "serving as an example, instance, or illustration." Any implementation described herein as "exemplary" is not necessarily to be construed as preferred or advantageous over other implementations.

If the specification states a component or feature "may," "can," "could," "should," "would," "preferably," "possibly," "typically," "optionally," "for example," "often," or "might" (or other such language) be included or have a characteristic, that a specific component or feature is not required to be included or to have the characteristic. Such a component or feature may be optionally included in some embodiments, or it may be excluded.

The term "electronically coupled," "electronically coupling," "electronically couple," "in communication with," "in electronic communication with," or "coupled" in the present disclosure refers to two or more elements or components being coupled through wired means and/or wireless means, such that signals, voltage/current, data and/or information may be transmitted to and/or received from these elements or components.

The use of the term "circuitry" as used herein with respect to components of a system or an apparatus should be understood to include particular hardware configured to perform the functions associated with the particular circuitry as described herein. The term "circuitry" should be understood broadly to include hardware and, in some embodiments, software for configuring the hardware. For example, in some embodiments, "circuitry" may include processing circuitry, communications circuitry, input/output circuitry, and the like. In some embodiments, other elements may provide or supplement the functionality of particular circuitry.

The term "mechanically coupled" in the present disclosure refers to two or more mechanical elements (for example, but not limited to, a frame, a surface, a support unit, a joint, etc.) being physically coupled in various ways such as directly, through intermediary elements, and/or using fastener(s), clasps, clamps, joints, pin joint, axle, hinge, adhesive, etc. The term "mechanically coupled" may refer to any of movable, turntable, swiveling, pivoting, fixed, and/or stationary, etc.

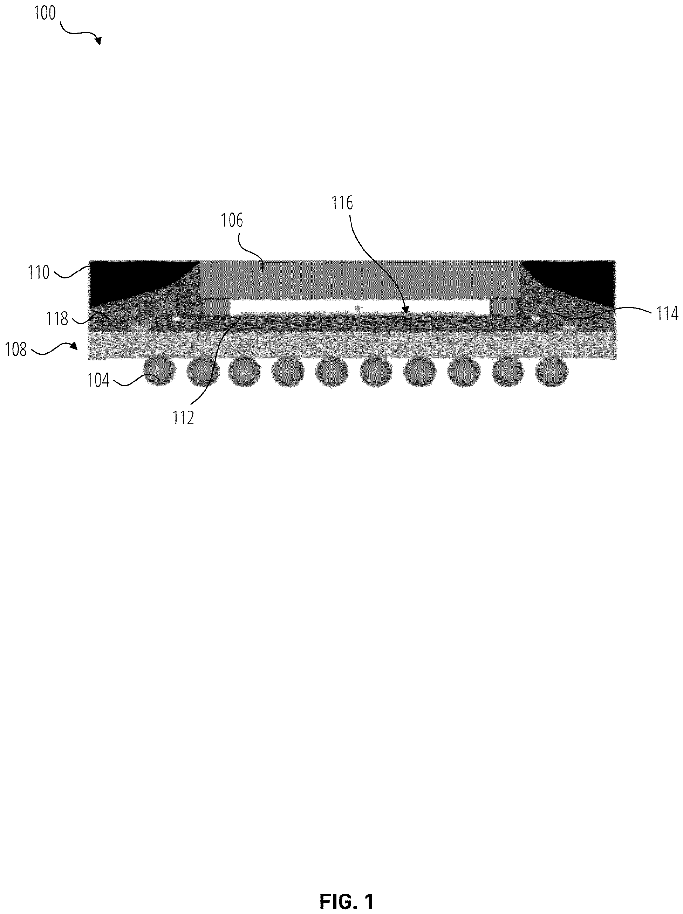

Referring now to FIG. 1, a schematic diagram illustrating an electro-optical device 100 is provided. An electro-optical device may include an electronic circuitry 112 disposed on or mounted on a substrate 108. The electronic circuitry 112 may be an electronic chip or die fabricated using silicone. The substrate 108 may be a laminate substrate and may be fabricated using dielectric material and electrically conductive traces configured to electronically couple to various electronic components. For example, the electrically conductive traces may be electronically coupled to one or more solder balls 104. The electronic circuitry 112 may be electronically coupled to the electrically conductive traces of the substrate using one or more bonding wires 114.

The electronic circuitry 112 may include one or more light sensitive components 116. The one or more light sensitive components 116 may be for example include photodiodes, pixels, light sensors such as infrared sensors, transistors, etc. In an example, the one or more light sensitive components 116 is a pixel array.

During the operation of the electro-optical device 100, a temperature of the electronic circuitry 112 may increase due to the operation of its various components. It is desirable to keep a junction temperature of the electronic circuitry 112 below a maximum junction temperature threshold to prevent harm to the electro-optical device 100. For example, a maximum junction temperature may indicate the temperature of the hottest point on the electronic circuitry 112, and may need to be kept below the maximum junction temperature threshold. For example, the maximum junction temperature threshold may be between 120°C to 170°C, for example about 150°C.

The electro-optical device 100 may include one or more molding material 110 and 118 to improve mechanical stability of the electro-optical device 100. For example, the molding materials may mechanically couple the transparent layer 106 to the substrate 108 in order to improve mechanical stability of the electro-optical device 100. The molding materials may for example include resin. However, the resin may not be heat conductive and may not dissipate the heat generated in the electronic circuitry 112 with a sufficient rate. Therefore, the junction temperature of the electronic circuitry 112 may increase to a point of failure.

Various embodiments of the present disclosure provide systems, devices and methods to facilitate the dissipation of the heat generated by the electronic circuitry in an electro-optical device and to maintain the junction temperature of the electronic circuitry below the maximum junction temperature.

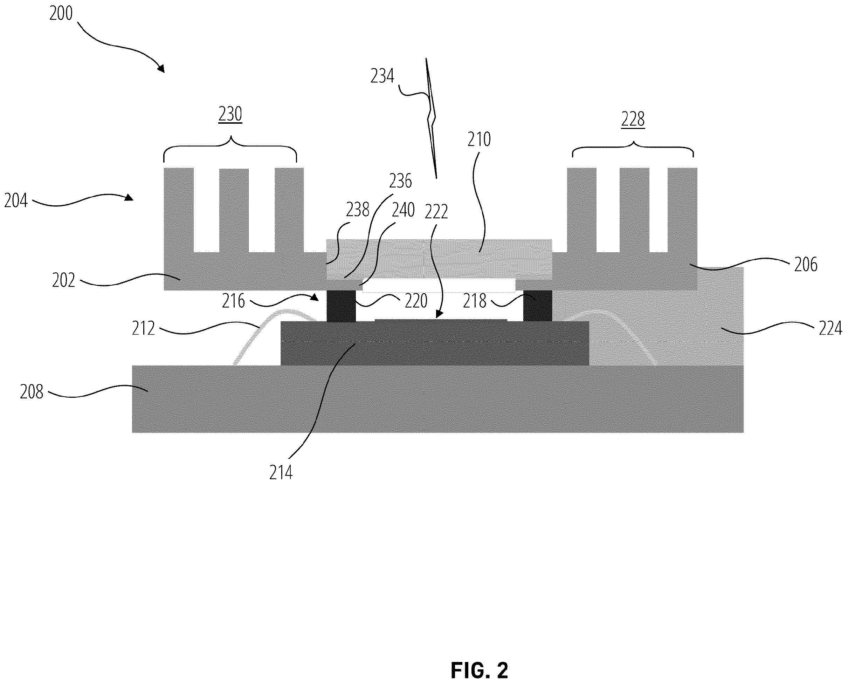

Referring now to FIG. 2 a schematic diagram illustrating an electro-optical device 200 is provided in accordance with various embodiments of the present disclosure. In various embodiments, a heat sink 204 is provided that embeds a transparent layer 210. The heat sink 204 may be configured to dissipate the heat generated by the operation of an electronic circuitry 214 and/or one or more light sensitive components 222 disposed on the electronic circuitry 214.

In various embodiments, the electro-optical device 200 includes the transparent layer 210, a heat sink 204 mechanically coupled to the transparent layer 210, an electronic circuitry 214 disposed on a substrate 208, and a support 216 configured to mechanically couple the heat sink 204 to the electronic circuitry. The support 216 may be configured to transfer heat generated by the electronic circuitry 112 to the heat sink 204.

In various embodiments, the transparent layer 210 includes at least one of a lens, a lens array, a protection layer, and/or a refractive filter. For example, a lens or a lens array may focus or otherwise manipulate an incident optical beam 234 to various sections of one or more light sensitive components 222 on the electronic circuitry 214. In some examples, the transparent layer 210 may function as a protection layer for the one or more light sensitive components 222. In various embodiments, the transparent layer 210 is made using at least one of glass, plastic, and/or any other transparent material.

In various embodiments, the electro-optical device 200 may be a light receiving device as described above, or a light emitting device. The electronic circuitry 214 may include one or more light emitting components and the transparent layer 210 may be configured to pass the emitted light through or otherwise manipulate the emitted light, for example by collimating the emitted light. In various embodiments, the heat generated by emitting light, receiving light, and/or various operation of the electronic circuitry 214 may be dissipated to the environment using heat sink 204.

In various embodiments, the heat sink 204 includes an opening configured to embed the transparent layer 210. For example, the heat sink 204 may include a cutout configured to fit the transparent layer 210. In various embodiments, the heat sink 204 is mechanically coupled to and embeds the transparent layer 210. The heat sink 204 may for example include a ledge 240 configured to support the transparent layer 210. The ledge 240 may be locate between the transparent layer 210 and the support 216.

In various embodiments, the heat sink 204 is mechanically coupled to the transparent layer 210 using a layer of glue 236 at one edge and directly coupled to the transparent layer 210 at another edge 238. For example, the ledge 240 of the heat sink 204 may be mechanically coupled to the support 216 using a layer of glue 236.

The electro-optical device 200 may include a cavity generated between the support 216, the transparent layer 210, the electronic circuitry 214, and/or the heat sink 204. The cavity may be a hollow area where the incident optical beam 234 travels through after passing through the transparent layer 210, or the light emitted by the electro-optical device 200 travels through before reaching the transparent layer 210. In various embodiments, the ledge 240 of the heat sink 204 may protrude in the cavity. In various embodiments, the ledge 240 of the heat sink 204 may be flushed with the support 216. In various embodiments, the heat generated by emitting light, receiving light, and/or various operation of the electronic circuitry 214 may reach the heat sink 204 through the cavity and/or through the support 216. In various embodiments, the support 216 is made using heat conductive material, for example heat conductive glue.

In various embodiments, the heat sink 204 fully surrounds the transparent layer 210 and/or the cavity. For example, the heat sink 204 may circularly surround the transparent layer 210 and/or the cavity. In some examples, the heat sink 204 may surround the transparent layer 210 in an oval-like shape, a square-like shape, or any other geometrical shape. In an example, the support 216 may be a single piece, having e.g. a ring shape mechanically coupling a single section heat sink that fully surrounds the transparent layer.

In various embodiments, the heat sink 204 includes multiple sections, where each section is mechanically coupled to a side of the transparent layer 210. For example, the heat sink 204 may include a first heat sink section 202 and a second heat sink section 206. The first heat sink section 202 may be mechanically coupled to one side of the transparent layer 210 and the second heat sink section 206 may be mechanically coupled to another side of the transparent layer 210.

In various embodiments, the support 216 mechanically couples the heat sink 204 to the electronic circuitry 214. The support 216 may have various shapes and/or mechanical forms. For example, support 216 may include a first pillar 220 and a second pillar 218, each mechanically coupling the heat sink 204 to the electronic circuitry 214. The first pillar 220 may be mechanically coupled with a first ledge of the heat sink 204 and the second pillar 218 may be mechanically coupled with a second ledge of the heat sink 204.

In various embodiments, the support 216 transfers generated heat by the electronic circuitry 214 to the heat sink 204, where the heat will be dissipated to the environment. In various embodiments, the first pillar 220 is configured to mechanically couple the first heat sink section to the electronic circuitry, and transfer heat generated by the electronic circuitry to the first heat sink section. In various embodiments, the second pillar 218 is configured to mechanically couple the second heat sink sections to the electronic circuitry and transfer heat generated by the electronic circuitry to the second heat sink section.

In various embodiments, the support 216 is made from a heat conductive material. For example, the support 216 (such as the first pillar 220 and second pillar 218) are made from heat conductive glue.

In example embodiments, the support 216 and the heat sink 204 are configured to reduce a thermal resistance from the electronic circuitry 214 to an environment surrounding the electro-optical device 200. For example, by using the heat sink 204 embedding the transparent layer 210, the thermal resistance of a path from the electronic circuitry 214 to the environment is reduced as compared to e.g., the electro-optical device 100 illustrated by FIG. 1 where the transparent layer 106 is surrounded by resin.

Therefore, in example embodiments, in the electro-optical device 200 the support 216 and the heat sink 204 are configured to maintain a maximum junction temperature of the electronic circuitry below a maximum junction temperature threshold. This may reduce the likelihood of a failure due to increased temperature in the electro-optical device 200.

In various embodiments, the heat sink 204 includes the first heat sink section 202 and the second heat sink section 206. The first pillar 220 may be configured to mechanically couple the first heat sink section 202 to the electronic circuitry 112, and the second pillar 218 may be configured to mechanically couple the second heat sink section 206 to the electronic circuitry 112.

In various embodiments, the heat sink 204 comprises one or more fins. The heat sink 204 may for example include one or more first fins 230 e.g., on the first heat sink section 202, and one or more second fins 228 e.g., on the second heat sink section 206. The one or more fins are configured to increase a thermal exchange surface between the heat sink and an environment and increase a thermal dissipation of the heat sink to the environment.

In various embodiments, the heat sink is made using copper or copper alloy. Copper has a high heat conductivity and may increase the thermal dissipation of the heat sink.

The electronic circuitry 214 may include one or more light sensitive components 222. The one or more light sensitive components 222 may be for example include photodiodes, pixels, light sensors such as infrared sensors, transistors, etc. In an example, the one or more light sensitive components 222 is a pixel array.

In various embodiments, the electronic circuitry 214 is disposed on a substrate 208. The electro-optical device 200 may be a wire-bonded electro-optical device. For example, the electro-optical device 200 may include one or more bonding wires 212. The one or more bonding wires 212 may be configured to electronically couple the electronic circuitry 214 or the components of the electronic circuitry 214 to one or more electrical conductive traces of the substrate 208.

In various embodiments, the electro-optical device 200 may include a molding material 224. The molding material 224 may be configured to surround the support 216 and mechanically couple to and hold together the heat sink, support, electronic circuitry, and the substrate. In example embodiments, the molding material 224 increases the mechanical robustness of the electro-optical device 200. The molding material 224 may include resin. In example embodiments, while the molding material 224 may have a high thermal resistance, using the heat sink and a low heat resistance path from the electronic circuitry 214 to the heat sink 204 allows for thermal dissipation and keeping the maximum junction temperature under the maximum junction temperature threshold. Therefore, in example embodiments, the electro-optical device described herein provides for high mechanical strength and high thermal dissipation.

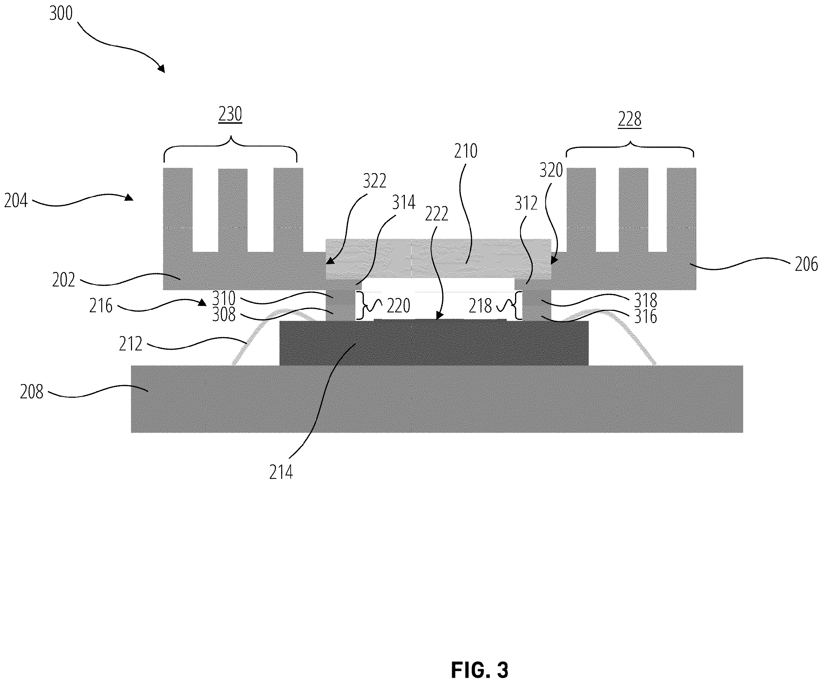

Referring now to FIG. 3 a schematic diagram illustrating an electro-optical device 300 is provided in accordance with various embodiments of the present disclosure. In various embodiments, the electro-optical device 300 includes a support 216. The support 216 may include a first layer made from copper and/or copper alloy, and a second solder layer made from for example tin and/or silver. The support 216 may have various forms and/or shapes as previously described.

In various embodiments, the support 216 includes the first pillar 220 and the second pillar 218. The first pillar 220 may include a first layer 308 of copper mechanically coupled to the electronic circuitry 214 and a first layer 310 of solder mechanically coupled to the first heat sink section 202. Similarly, the second pillar 218 may include a second layer 316 of copper mechanically coupled to the electronic circuitry 214 and a second layer 318 of solder mechanically coupled to the second heat sink section 206.

In various embodiments, the first heat sink section 202 may include a first ledge 314 and the second heat sink section 206 may include a second ledge 312. In various embodiments, an end of either ledge may extend in the cavity or be flushed with an interior of the support 216. In various embodiments, the first ledge 314 is disposed between the first pillar and the transparent layer and mechanically coupled to the transparent layer using glue. In various embodiments, the second ledge 312 is disposed between the second pillar and the transparent layer and mechanically coupled to the transparent layer using glue. In various embodiments, another surface of the heat sink is directly in contact with the transparent layer. For example, the surface 320 or the surface 322 of the heat sink 204 may be mechanically coupled to and directly contact the transparent layer 210.

In various embodiments, first heat sink section 202 includes one or more first fins 230 and the second heat sink section 206 includes one or more second fins 228. In various embodiments, the one or more first fins 230 and the one or more second fins 228 are configured to increase a thermal exchange surface between the heat sink and the environment and increase a thermal dissipation of the heat sink.

In various embodiments, the heat sink may include one section surrounding the transparent layer, for example with a circular, oval, and/or any other shapes. In various embodiments, the heat sink may include one or more fins that each also surround the transparent layer.

In various embodiments, the heat sink may also be mechanically coupled to the support, electronic circuitry, and/or the substrate using molding material, for example resin. For example, the area surrounding the support, or on either sides of the first pillar and the second pillar may be filled with the molding material similar to the molding material 224 illustrated and described with reference to FIG. 2. In example embodiments, using molding material increases the mechanical robustness of the electro-optical device 300.

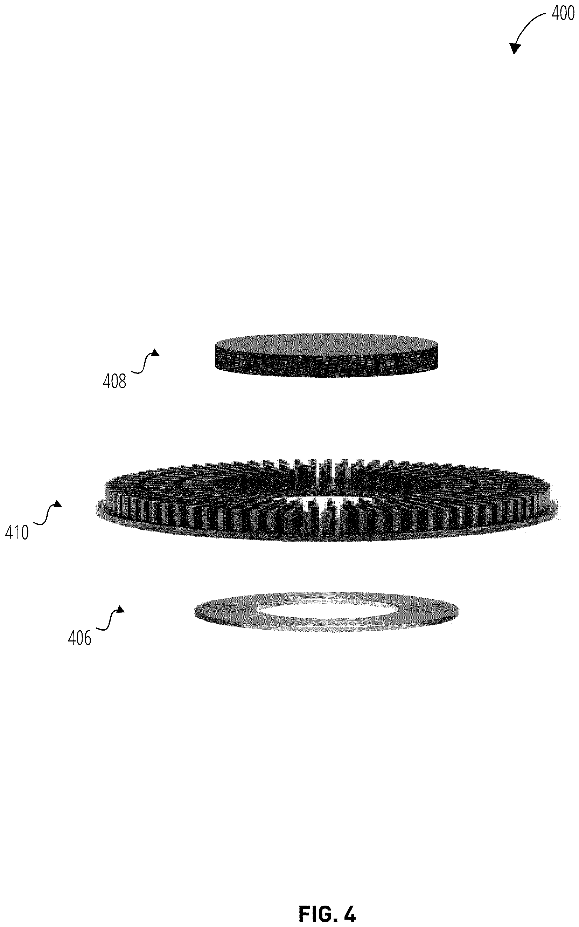

Referring now to FIG. 4 a schematic diagram 400 illustrating a disc shaped transparent layer 408, a ring shaped heat sink 410, and a ring shaped support 406 is provided in accordance with various example embodiments of the present disclosure. In various embodiments, the heat sink 410 is shaped to embed the transparent layer 408 and the support 406 is shaped to mechanically couple the heat sink 410 to an electronic circuitry. The shapes for the support, heat sink, and transparent layer illustrated by FIG. 4 are for example purposes and they may have various other shapes, such as oval, square, rectangular, etc., as previously described.

In various embodiments, the heat sink may have variously shaped and/or arranged fins. For example the fins may extend radially from a center of the heat sink or may be arranged as concentric rings on the heat sink.

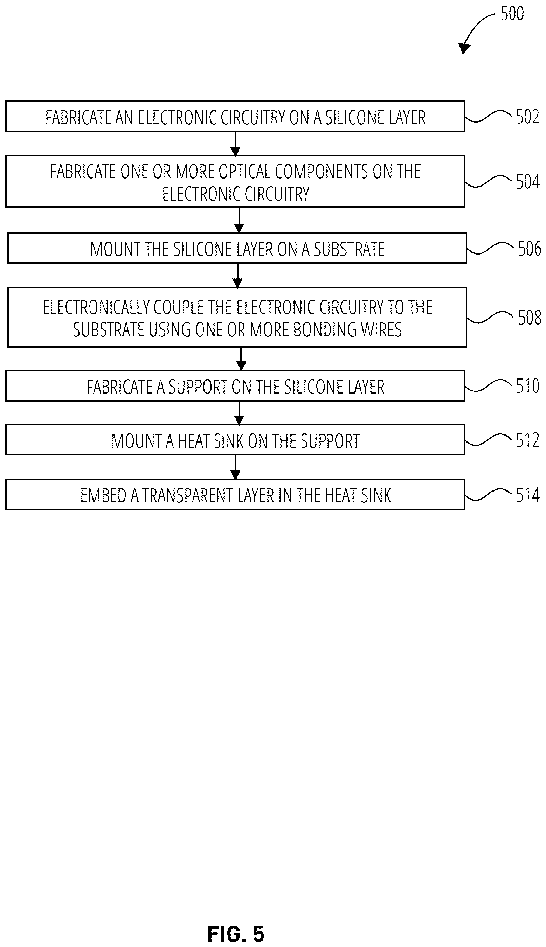

FIG. 5 is a flowchart illustrating a method 500 for fabricating an electro-optical device in accordance with various embodiments of the present disclosure. For example, method 500 may be used to fabricate electro-optical device 200 described with reference to FIG. 2 or electro-optical device 300 described with reference to FIG. 3.

In various embodiments, method 500 fabricates an electronic circuitry 214 on a silicone layer at block 502. In various embodiments, method 500 fabricates one or more optical components, such as light sensitive components or light emitting components on the electronic circuitry 214 at block 504. In various embodiments, method 500 mounts the silicone layer or the electronic circuitry 214 on a substrate 208 at block 506.

In various embodiments, method 500 electronically couples the electronic circuitry 214 to the substrate 108 using one or more bonding wires 212 at block 508. In various embodiments, method 500 fabricates a support 216 on the silicone layer or the electronic circuitry 214 at block 510. In various embodiments, method 500 includes mounting a heat sink 204 on the support 216 at block 512. In various embodiments, method 500 embeds a transparent layer 210 in the heat sink 204 at block 514. In various embodiments, the fabrication is performed in the order illustrated by FIG. 5. In various embodiments, the fabrication may be performed in any other order(s).

Many modifications and other embodiments of the disclosures set forth herein will come to mind to one skilled in the art to which these disclosures pertain having the benefit of teachings presented in the foregoing descriptions and the associated drawings. Although the figures show certain components of apparatuses and systems according to various embodiments described herein, it is understood that various other components may be used in conjunction with systems according to various embodiments. Therefore, it is to be understood that the disclosures are not to be limited to the specific embodiments disclosed and that modifications and other embodiments are intended to be included within the scope of the appended claims. Moreover, the steps in methods according to various embodiments described above may not necessarily occur in the order depicted in the accompanying diagrams, and in some cases one or more of the steps depicted may occur substantially simultaneously, or additional steps may be involved. Although specific terms are employed herein, they are used in a generic and descriptive sense only and not for purposes of limitation.

Additionally, the section headings used herein are provided for consistency with the suggestions under 37 C.F.R. 1.77 or to otherwise provide organizational cues. These headings shall not limit or characterize the disclosure(s) set out in any claims that may issue from this disclosure.

Use of broader terms such as "comprises," "includes," and "having" should be understood to provide support for narrower terms such as "consisting of," "consisting essentially of," and "comprised substantially of' Use of the terms "optionally," "may," "might," "possibly," and the like with respect to any element of an embodiment means that the element is not required, or alternatively, the element is required, both alternatives being within the scope of the embodiment(s). Also, references to examples are merely provided for illustrative purposes, and are not intended to be exclusive.

While this detailed description has set forth some embodiments of the present disclosure, the appended claims cover other embodiments of the present disclosure which differ from the described embodiments according to various modifications and improvements.

## Claims

1. An electro-optical device comprising:
a transparent layer;
a heat sink mechanically coupled to and embedding the transparent layer, wherein the heat sink comprises:
a first heat sink section; and
a second heat sink section;
an electronic circuitry disposed on a substrate;
a first pillar configured to:
mechanically couple the first heat sink section to the electronic circuitry; and
transfer heat generated by the electronic circuitry to the first heat sink section; and
a second pillar configured to:
mechanically couple the second heat sink sections to the electronic circuitry; and
transfer heat generated by the electronic circuitry to the second heat sink section.

2. The electro-optical device of claim 1, wherein the first pillar and the second pillar comprise heat conductive glue.

3. The electro-optical device of claim 1, wherein:
the first pillar comprises a first layer of copper mechanically coupled to the electronic circuitry and a first layer of solder mechanically coupled to the first heat sink section; and
the second pillar comprises a second layer of copper mechanically coupled to the electronic circuitry and a second layer of solder mechanically coupled to the second heat sink section.

4. The electro-optical device of claim 1, wherein:
the first heat sink section comprises a first ledge disposed between the first pillar and the transparent layer and mechanically coupled to the transparent layer using glue; and
the second heat sink section comprises a second ledge disposed between the second pillar and the transparent layer and mechanically coupled to the transparent layer using glue.

5. The electro-optical device of claim 1, wherein the first heat sink section comprises one or more first fins and the second heat sink section comprises one or more second fins, wherein the one or more first fins and the one or more second fins are configured to:
increase a thermal exchange surface between the heat sink and an environment; and
increase a thermal dissipation of the heat sink.

6. An electro-optical device comprising:
a transparent layer;
a heat sink comprising a ledge, wherein the ledge is mechanically coupled to the transparent layer;
an electronic circuitry disposed on a substrate; and
a support configured to:
mechanically couple the ledge of the heat sink to the electronic circuitry; and
transfer heat generated by the electronic circuitry to the heat sink.

7. The electro-optical device of claim 6, wherein the ledge of the heat sink is configured to mechanically couple to the transparent layer using glue.

8. The electro-optical device of claim 7, wherein the heat sink comprises one or more fins configured to:
increase a thermal exchange surface between the heat sink and an environment; and
increase a thermal dissipation of the heat sink.

9. The electro-optical device of claim 6, comprising a cavity, wherein the cavity is generated between the transparent layer, the electronic circuitry, and the support.

10. The electro-optical device of claim 6, wherein:
the support comprises a first pillar and a second pillar;
the heat sink comprises a first heat sink section and a second heat sink section;
the first pillar is configured to mechanically couple the first heat sink section to the electronic circuitry; and
the second pillar is configured to mechanically couple the second heat sink section to the electronic circuitry.

11. The electro-optical device of claim 6, wherein the support comprises heat conductive material.

12. The electro-optical device of claim 11, wherein the support and the heat sink are configured to reduce a thermal resistance from the electronic circuitry to an environment.

13. The electro-optical device of claim 11, wherein the support and the heat sink are configured to maintain a maximum junction temperature of the electronic circuitry below a maximum junction temperature threshold.

14. The electro-optical device of claim 11, wherein the heat sink comprises copper or copper alloy.

15. The electro-optical device of claim 6, wherein the transparent layer comprises at least one of a lens, a lens array, a protection layer, or a refractive filter.

16. The electro-optical device of claim 6, wherein the electronic circuitry comprises at least one of a light sensor, a photodiode, or a pixel.

17. The electro-optical device of claim 16 further comprising one or more bonding wires configured to electronically couple at least one of the light sensor, the photodiode, or the pixel to one or more electrical conductive traces of the substrate.

18. The electro-optical device of claim 6 further comprising a molding material configured to:
surround the support;
mechanically couple to and hold together the heat sink, the support, the electronic circuitry, and the substrate.

19. An electro-optical device comprising:
a transparent layer;
a heat sink mechanically coupled to the transparent layer;
an electronic circuitry disposed on a substrate; and
a support configured to:
mechanically couple the heat sink to the electronic circuitry; and
transfer heat generated by the electronic circuitry to the heat sink.

20. The electro-optical device of claim 19, wherein:
the heat sink comprises:
an opening configured to embed the transparent layer; and
one or more fins configured to:
increase a thermal exchange surface between the heat sink and an environment; and
increase a thermal dissipation of the heat sink;
the electronic circuitry comprises one or more light sensitive components; and
the support surrounds the one or more light sensitive components.
